# EUROPEAN PATENT SPECIFICATION

(11) **EP 0 573 240 B1**
(45) Date of publication and mention of the grant of the patent: **27.01.1999**
(21) Application number: 93304211.1
(22) Date of filing: 01.06.1993
(51) Int. Cl.: G11C 5/14

(54) **Reference voltage generator**
Referenz Spannungsgenerator
Générateur de tension de référence

(30) Priority: 30.05.1992 KR 941192
(43) Date of publication of application: 08.12.1993
(73) Proprietor: SAMSUNG ELECTRONICS CO., LTD., Suwon-city, Kyungki-do 441-373 (KR)
(72) Inventor: Lee, Seung-Hun, Suwon-city, Kyungki-do (KR)
(74) Representative: Stanley, David William

(56) References cited:
- DE-A- 4 018 457
- DE-A- 4 139 163
- ELECTRONIC DESIGN, vol. 37, 8 June 1989 HASBR.HEIGHTS,NJ,USA, page 75 XP 000096846 G. RAUH 'CONTROL THE VPP TO FLASH EEPROMS'

## Description

The present invention relates to reference voltage generators - for example, for use in semiconductor memory devices.

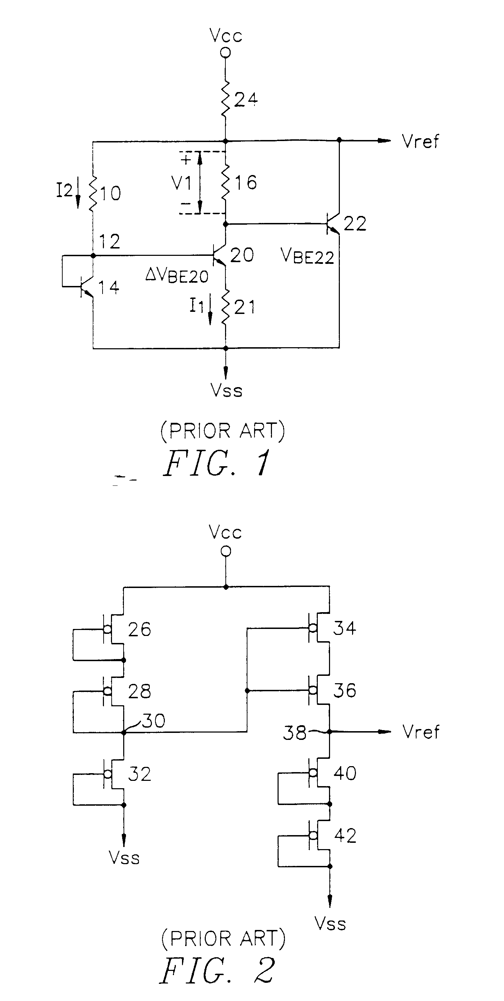

The miniaturization of semiconductor memory devices of high complexity requires a reference voltage generating circuit for supplying an internal source voltage lower by a given value than an external source voltage. In this case, it is required that the reference voltage generating circuit be designed so as to provide a stable reference voltage regardless of the various variations of, for example, environmental temperature, external source voltage, process parameters, etc. To this end, there has been proposed a band-gap reference voltage generating circuit as shown in Figure 1 of the accompanying diagrammatic drawings.

Referring to Figure 1, the band-gap reference voltage generating circuit includes three bipolar transistors 14, 20 and 22 supplied with a current via a current supply resistor 24. The first transistor 14 has a diode-connected collector-base and is connected between a reference voltage terminal Vref and ground voltage terminal Vss. The second transistor 20 has a base connected through a node 12 to the collector of the first transistor 14, a collector connected through a resistor 16 to the reference voltage terminal Vref and an emitter connected through a resistor 21 to the ground voltage Vss. There is also a resistor 10 connected between the node 12 and reference voltage terminal Vref. The third transistor 22 has a collector connected to the reference voltage terminal, an emitter to the ground voltage and a base to the collector of the second transistor 20. This circuit causes the base-emitter voltage (∂V_{BE}/∂T ≅ -2.2mV/°C) with a negative thermal coefficient to counterbalance the thermal voltage (V_{T}=kT/q, ∂Vt/∂T = 0.086mV/°C) with a positive thermal coefficient in order to generate a stable reference voltage output with respect to temperature variation. More specifically, the reference voltage output Vref is the sum of the voltage V1 across the resistor 16 and the base-emitter voltage V_{BE22} of the third transistor 22. The voltage V1 depends on the variation ΔV_{BE20} of the base-emitter voltage of the second transistor 20. Assuming that the resistors 16 and 21 have respective values R16 and R21 and that the currents passing through the resistors 21 and 10 are respectively I1 and I2, Eqs. (1) and (2) may be obtained as follows:${\text{ΔV}}_{\text{BE20}} {\text{= I1 • R21 = V}}_{\text{BE14}} {\text{- V}}_{\text{BE20}} {\text{= V}}_{\text{T}} \text{ln(I2/I1)}$${\text{V1 = (R16/R21) • ΔV}}_{\text{BE20}} {\text{= V}}_{\text{T}} \text{• (R16/R21)ln(I2/I1)}$

Here, V_{T} (=kT/q) is a thermal voltage with a positive thermal coefficient, k Boltzman constant, T absolute temperature and q charge quantity. Hence, the reference voltage Vref is determined by the base-emitter voltage V_{BE22} of the third transistor 22 with the negative thermal coefficient and the thermal voltage V_{T} with the positive thermal coefficient, expressed by Eq. (3).${\text{Vref = V}}_{\text{BE22}} {\text{+ V}}_{\text{T}} \text{(R16/R21)ln(I2/I1)}$

Thus, the reference voltage output Vref is stabilized with respect to temperature variation. Moreover the bipolar transistors work depending on the relatively stable base-emitter voltage V_{BE22} under a saturation condition, thus providing a relatively stable reference voltage with respect to the variation of the external source voltage.

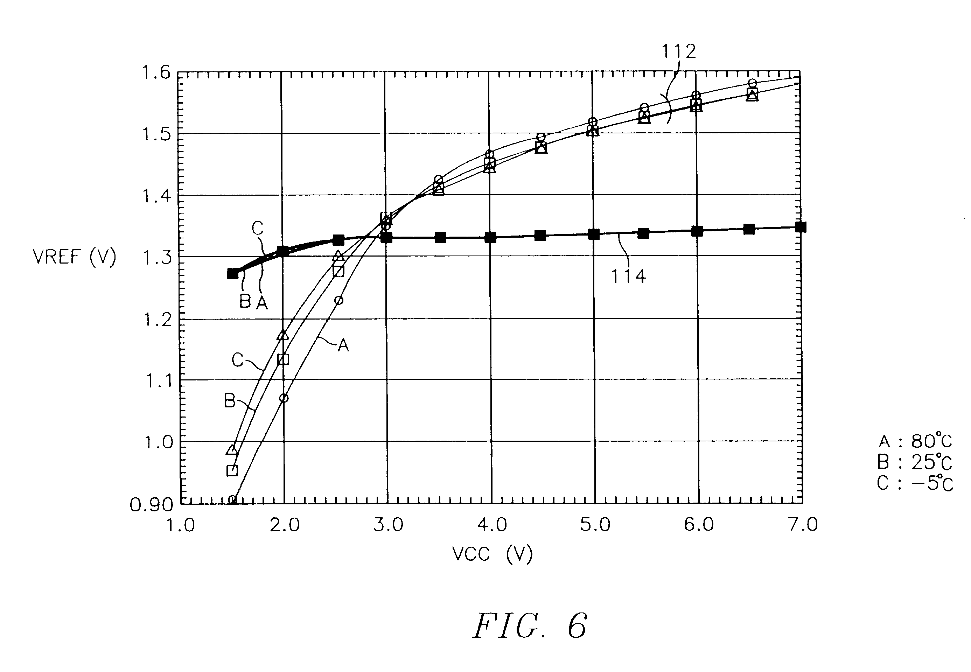

However, a DRAM device using a reference voltage from the band-gap reference voltage generating circuit requires a back bias generator to supply a negative substrate voltage V_{BB} to stabilize the substrate. The back bias generator works only when the substrate voltage V_{BB} exceeds a given value. The substrate voltage V_{BB} is undesirably transferred via the polysilicon resistors of the band-gap reference voltage generating circuit and parasitic capacitances formed in the substrate to the respective circuit connections, thus varying the reference voltage output Vref. Moreover, the transistors used in the circuit work under a saturation condition, thus increasing the stand-by current. In addition, if the band-gap reference voltage generating circuit is used in a DRAM device, the substrate (mainly including MOS transistors) requires an additional processing step for forming the bipolar transistors. Further, as shown by curve 112 in Figure 6 of the accompanying diagrammatic drawings, the band-gap reference voltage generating circuit has a high set-up voltage (about 2.5V) and shows a large fluctuation of the reference voltage, with respect to the temperature variation, at the low external source voltage.

Figure 2 shows another conventional reference voltage generating circuit including a plurality of PMOS transistors. The PMOS transistors 26, 28 and 32 with their channels connected in series have diode-connected gates and drains producing the threshold voltage Vtp of the PMOS transistor 32 at the connection point 30. The PMOS transistors 40 and 42 with the channels connected in series have diode-connected gates and drains producing the output reference voltage 2Vtp at the reference voltage terminal 38. The voltage Vtp at the connection point 30 is applied to the gates of the PMOS transistors 34 and 36 with the channels connected in series to stabilize the reference voltage with respect to the external source voltage variation. However, it can not counterbalance the variation of the reference voltage due to the temperature variation.

DE-A-4018457 describes another reference voltage generator. A source voltage is connected to ground via a resistor, the channel of a first MOS transistor and the channel of a second MOS transistor. The node between the resistor and the first MOS transistor is the reference voltage node and is connected to the gate of the first MOS transistor. The node between the first and second MOS transistors is connected to the gate of the second MOS transistor. The reference voltage node is also connected to ground via two diodes and the channel of a third MOS transistor. The gate of the third MOS transistor is connected to the node between the first and second MOS transistors. When there is an increase in temperature, the threshold voltages of the diodes reduce, thus lowering the reference voltage. This lowering of the reference voltage reduces the voltage at the node divided by the first and second MOS transistors. Since the voltage from that node is applied to the gate of the third MOS transistor, the transconductance of the third MOS transistor is reduced, thus raising, i.e. stabilizing, the output voltage.

Preferred embodiments of the present invention aim to provide a reference voltage generating circuit using CMOS transistors for generating a stable reference voltage with respect to variations of temperature and external source voltage.

It is another aim to provide a reference voltage generating circuit using CMOS transistors for generating a stable reference voltage having low power consumption and low set-up voltage.

It is also another aim to provide a reference voltage generating circuit that has a simple construction easily applied to DRAM devices.

According to the present invention, there is provided a reference voltage generating circuit for converting a source voltage (Vcc) into a reference voltage (Vref), the circuit comprising:
a source voltage terminal for receiving the source voltage (Vcc);
a ground voltage terminal for receiving a ground voltage;
a reference voltage terminal for outputting the reference voltage (Vref);
a first circuit portion (100, 102, 106; 110) connected between the source voltage terminal and the ground voltage terminal (Vss) having an output voltage node (104) and a reference voltage node (101) for connecting to the reference voltage terminal and from which the reference voltage (Vref) and output voltage (V104) are derivable respectively, the first circuit portion having a first resistor (100) between the source voltage terminal (Vcc) and the reference voltage node (101) and a second resistor (102) between the reference voltage node (101) and the output voltage node (104) and a positive thermal coefficient component (106; 110) connected between the output voltage node (104) and the ground voltage terminal (Vss) for increasing the output voltage (V104) with increasing temperature; and
a second circuit portion having a negative thermal coefficient component (108; 108') connected between the reference voltage terminal and the output voltage node for decreasing the reference voltage (Vref) relative to the output voltage (V104) with increasing temperature;
wherein the positive and negative thermal coefficient components counterbalance each other so as to stabilize the reference voltage (Vref) with respect to temperature variations.

Preferred embodiments of the invention are set forth in the dependent claims.

For a better understanding of the invention, and to show how the same may be carried into effect, reference will now be made, by way of example, to Figures 3 to 7C of the accompanying diagrammatic drawings, in which:
Figure 3 is a schematic diagram of one example of a reference voltage generating circuit with a CMOS transistor according to an embodiment of the present invention;
Figure 4 is a schematic diagram of one example of a reference voltage generating circuit with a CMOS transistor according to another embodiment of the present invention;
Figure 5 is a schematic diagram of one example of a reference voltage generating circuit with a CMOS transistor according to a further embodiment of the present invention;
Figure 6 is a graph for illustrating reference voltage versus source voltage characteristic curves of examples of reference voltage generating circuits embodying the invention, compared to a conventional band-gap reference voltage generating circuit; and
Figures 7A to 7C are respectively schematic diagrams of examples of reference voltage generating circuits with CMOS transistors according to various embodiments of the present invention.

In the figures, like reference numerals denote like or corresponding parts.

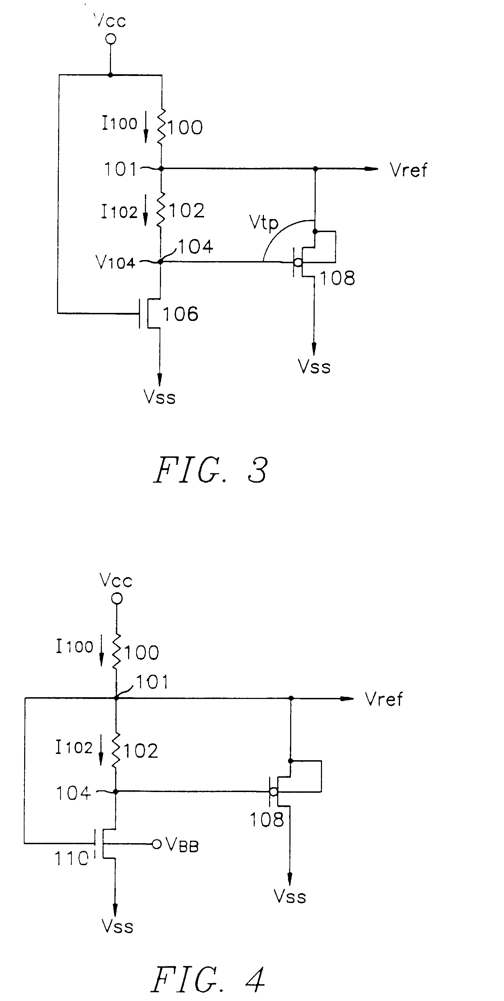

Referring to Figure 3, first and second resistors 100 and 102 and the channel of an NMOS transistor 106 are connected in series between an external source voltage terminal Vcc and ground voltage terminal Vss. The gate of the NMOS transistor 106 is connected with the source voltage terminal Vcc. A PMOS transistor 108 has its channel connected between a reference voltage terminal Vref and the ground voltage terminal Vss and its gate to the connection point 104 of the second resistor 102 and the drain of the NMOS transistor 106. The reference voltage terminal Vref is also connected to the connection point 101 of the first and second resistors 100 and 102. The substrate of the PMOS transistor 108 is connected with the reference voltage Vref instead of the source voltage Vcc. The reason is to prevent the "body effect" whereby an increase of the external source voltage Vcc increases the threshold voltage of the PMOS transistor 108, resulting in the increase of the reference voltage Vref. if the substrate is connected to the external source voltage Vcc.

In operation, the NMOS transistor 106 is normally turned on due to the gate being connected with the external source voltage Vcc, thus causing a current I102 to flow through the path formed of the first and second resistors 100 and 102 and the channel of the transistor 106. Then the connection point 104 has a voltage V104, whose level is low enough to turn on the PMOS transistor 108. Hence the output reference voltage is the sum of the voltage V104 and the turn-on voltage Vtp(on) of the PMOS transistor 108. Meanwhile, if the external source voltage Vcc increases, the transconductance Gm of the NMOS transistor 106 is also increased due to the corresponding increase of the gate voltage. Accordingly the voltage V104 of the connection point 104 is lowered so as to more intensely turn on the PMOS transistor 108, so that the threshold voltage Vtp of the PMOS transistor 108 formed across the second resistor 102 prevents the reference voltage output Vref from increasing. Alternatively, if the external source voltage decreases, the transconductance Gm of the NMOS transistor 106 is also decreased, due to the decrease of the gate voltage. Accordingly, the voltage V104 at the connection point 104 is increased so as to slightly turn off the PMOS transistor 108, so that the reference voltage output Vref may be prevented from decreasing. Thus the illustrated circuit provides a stable reference voltage output Vref with respect to the variation of the external source voltage Vcc.

Now the thermal compensation of the illustrated circuit will be described.

When the PMOS transistor 108 is turned on under the normal condition of the circuit, the current I102 passing through the second resistor R102 may be expressed by Eq. (4).$\text{I102 = Vtp/R102}$

Here, Vtp represents the threshold or turn-on voltage of the PMOS transistor 108, which is well known in the art to have a negative thermal coefficient inversely proportional to the temperature variation. On the contrary, the channel resistance of the NMOS transistor 106 has a positive thermal coefficient because it is increased with temperature due to the corresponding decrease of the mobility of the carriers in the channel. Thus, while the channel resistance of the NMOS transistor 106 increases with temperature resulting in the increase of the voltage V104 of the connection point 104, the threshold voltage Vtp of the PMOS transistor 108 decreases with temperature, so as to provide a stable constant reference voltage output Vref. Hence the reference voltage output Vref may be maintained substantially constant with respect to temperature variation.

In addition, the circuit of Figure 3 includes a CMOS transistor, considerably decreasing the stand-by current, and does not require any separate complicated processing steps when applied to DRAMs. The set-up voltage level of the circuit is determined by Eqs. (5) and (6).$\text{I100 > I102}$$\text{Vcc > (R100/R102) • Vtp + Vref}$

The set-up voltage must be equal to or higher than the sum of the reference voltage Vref and the voltage V100 across the first resistor R100, which is lower than that of the band-gap reference voltage generating circuit using bipolar transistors. Practically the set-up voltage of the illustrated reference voltage generating circuit may be set to around 1.6V.

Another embodiment of the present invention is shown in Figure 4, where the same reference numerals are used for the parts corresponding with those of the circuit of Figure 3. The first and second resistors R100 and R102 and the channel of the NMOS transistor 110 are connected in series between the external source voltage Vcc and ground voltage Vss. The gate of the NMOS transistor 110 is connected with the connection point 101 of the first and second resistors 100 and 102. The channel of the PMOS transistor 108 is connected between the reference voltage terminal Vref connected with the connection point 101 and the ground voltage Vss, and the gate to the drain of the NMOS transistor 110. The substrate of the PMOS transistor 108 is also connected with the reference voltage Vref in order to prevent the "body effect", as in Figure 3. As easily perceived from the above, the difference between the present embodiment and the previous embodiment of Figure 3 is that the gate of the NMOS transistor 110 is connected with the reference voltage Vref so as to feed-back the reference voltage output Vref to the gate of the NMOS transistor 110. Thus the variation of the reference voltage Vref may be minimized.

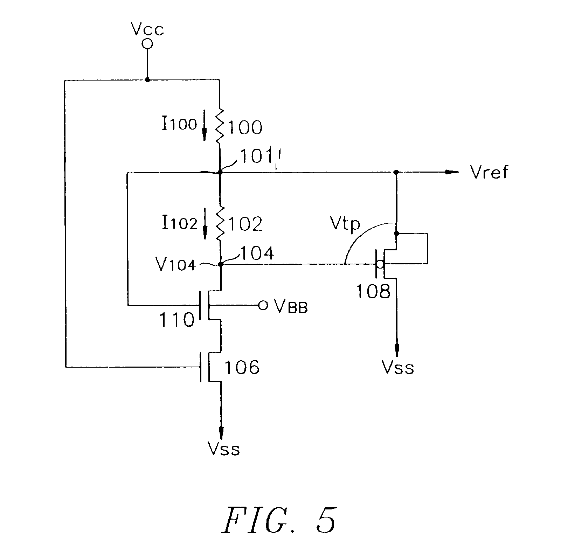

A further embodiment of the present invention is shown in Figure 5, where the first and second resistors R100 and R102 and the channels of the NMOS transistors 110 and 106 are connected in series between the external source voltage Vcc and ground voltage Vss. The gate of the NMOS transistor 106 is connected with the source voltage Vcc and the gate of the NMOS transistor 110 with the connection point 101 of the first and second resistors 100 and 102. The connection point 101 is also connected with the reference voltage Vref. The channel of the PMOS transistor 108 is connected between the reference voltage Vref and ground voltage Vss, and the gate to the connection point 104 of the second resistor 102 and the drain of the NMOS transistor 110. As readily perceived from the above, the present embodiment is obtained by combining the embodiments of Figures 3 and 4. The additional NMOS transistor 106 assists in stabilizing the reference voltage even with increase of the substrate voltage V_{BB}. Thus, in the embodiment of Figure 4, if the external source voltage Vcc increases, the substrate voltage V_{BB} applied to the substrate of the NMOS transistor 110 is also increased. Then, as in the case of the PMOS transistor 108, the "body effect" increases the resistance of the NMOS transistor 110 to increase the reference voltage Vref because of the voltage at the connection point 104 being increased. However, the increase of the external source voltage Vcc decreases the channel resistance of the additional NMOS transistor 106 so as to keep the voltage of the connection point 104 constant, thus minimizing the variation of the reference voltage output Vref. The additional NMOS transistor 106 may be omitted with a circuit for generating a relatively low reference voltage. The present embodiment is particularly effective in minimizing the variation of the reference voltage Vref in a high source voltage region.

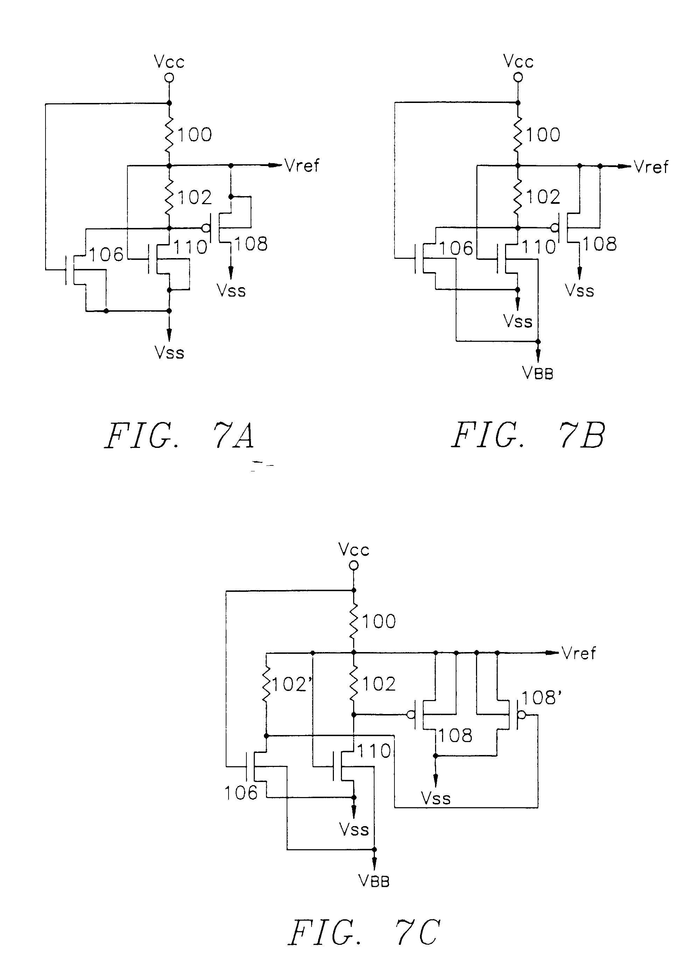

Referring to Figures 7A to 7C, further examples of various different embodiments of the present invention are illustrated. As shown in the drawings, the NMOS transistors 110 and 106 can be connected in parallel to each other and the substrates thereof can be connected to the ground voltage or the back-bias voltage V_{BB}. Further, as shown in Figure 7C, a PMOS transistor 108' can be connected in parallel to the PMOS transistor 108, which has its gate connected to a connection point formed between the drain of the NMOS transistor 106 and a resistor 102'. The resistor 102' is connected between the reference voltage output Vref and the drain of the NMOS transistor 106.

Referring to Figure 6, the curve 112 represents the characteristics of a conventional band-gap reference voltage generating circuit (as discussed above) and the curve 114 those of the illustrated circuits. While the illustrated circuits need a low set-up voltage and provide a substantially stable reference voltage Vref with variations of temperature and external source voltage, the conventional circuit needs a high set-up voltage and provides an unstable reference voltage Vref with variations of temperature and external source voltage.

Although examples of specific constructions of the invention have been illustrated and described herein, it is not intended that the invention be limited to the elements and constructions disclosed. One skilled in the art will easily recognize that the particular elements or subconstructions may be used without departing from the scope of the invention.

The term "ground potential" (or like terms such as "ground voltage" or "earth" potential or voltage) is used conveniently in this specification to denote a reference potential. As will be understood by those skilled in the art, although such reference potential may typically be zero potential, it is not essential that it is so, and may be a reference potential other than zero.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s).

## Claims

1. A reference voltage generating circuit for converting a source voltage (Vcc) into a reference voltage (vref), the circuit comprising:
a source voltage terminal for receiving the source voltage (Vcc);
a ground voltage terminal for receiving a ground voltage;
a reference voltage terminal for outputting the reference voltage (Vref);
a first circuit portion (100, 102, 106; 110) connected between the source voltage terminal and the ground voltage terminal (Vss) having an output voltage node (104) and a reference voltage node (101) for connecting to the reference voltage terminal and from which the reference voltage (Vref) and output voltage (V104) are derivable respectively, the first circuit portion having a first resistor (100) between the source voltage terminal (Vcc) and the reference voltage node (101) and a second resistor (102) between the reference voltage node (101) and the output voltage node (104) and a positive thermal coefficient component (106; 110) connected between the output voltage node (104) and the ground voltage terminal (Vss) for increasing the output voltage (V104) with increasing temperature; and
a second circuit portion having a negative thermal coefficient component (108; 108') connected between the reference voltage terminal and the output voltage node for decreasing the reference voltage (Vref) relative to the output voltage (V104) with increasing temperature;
wherein the positive and negative thermal coefficients counterbalance each other so as to stabilize the reference voltage (Vref) with respect to temperature variations.

2. A reference voltage generating circuit as defined in claim 1, wherein the positive thermal coefficient component is a NMOS transistor (106), and the channel of the NMOS transistor (106) being connected in series between the output voltage node and the ground voltage terminal (Vss).

3. A reference voltage generating circuit as defined in claim 2 in which:
the NMOS transistor (106) has its gate connected to the source voltage terminal or reference voltage terminal.

4. A reference voltage generating circuit as defined in any preceding claim, wherein the negative thermal coefficient component is a PMOS transistor (108) whose channel is connected between the reference voltage terminal and ground voltage terminal (Vss) and whose gate is connected to the output voltage node (104).

5. A reference voltage generating circuit as defined in claim 4 in which the substrate of the PMOS transistor is connected to the reference voltage terminal.

6. A reference voltage generating circuit as defined in any preceding claim, further comprising a feed-back means for feeding-back the reference voltage to the positive thermal coefficient component to assist in stabilizing the reference source voltage.

7. A reference voltage generating circuit as defined in claim 2 or claim 3 further comprising a second NMOS transistor (110), whose channel is connected between the output voltage node (104) and the source of the first NMOS transistor (106) and whose gate is connected to the reference voltage terminal.

8. A reference voltage generating circuit as defined in claim 7 in which the first and second NMOS transistors are connected with their channels in parallel.

9. A reference voltage generating circuit as defined in claim 2 or 3, wherein the negative thermal coefficient component comprises a PMOS transistor (108), whose channel is connected between the reference voltage terminal and ground voltage terminal (Vss) and whose gate is connected to the output voltage node (104), further comprising a second PMOS transistor (108') with its channel connected in parallel to the channel of the first PMOS transistor (108).

10. A reference voltage generating circuit as defined in Claim 7, 8 or 9, wherein the substrates of the first and second NMOS transistors (106, 110) are connected in common to either ground voltage or a back-bias voltage.

## Patentansprüche

1. Referenzspannungs-Erzeugungsschaltkreis zum Konvertieren einer Quellenspannung (Vcc) in eine Referenzspannung (Vref), wobei der Schaltkreis aufweist:
einen Quellenspannungsanschluß zum Aufnehmen der Quellenspannung (Vcc);
einen Erdungsspannungsanschluß zum Aufnehmen einer Erdungsspannung;
einen Referenzspannungsanschluß zum Ausgeben der Referenzspannung (Vref);
einen ersten Schaltkreisabschnitt (100, 102, 106; 110), der zwischen dem Quellenspannungsanschluß und dem Erdungsspannunganschluß (Vss) verbunden ist, der einen Ausgangsspannungsknoten (104) und einen Referenzspannungsknoten (101) zum Verbinden mit dem Referenzspannungsanschluß besitzt und von denen die Referenzspannung (Vref) und die Ausgangsspannung (V104) jeweils abgreifbar sind, wobei der erste Schaltkreisabschnitt einen ersten Widerstand (100) zwischen dem Quellenspannungsanschluß (Vcc) und dem Referenzspannungsknoten (101) und einen zweiten Widerstand (102) zwischen dem Referenzspannungsknoten (101) und dem Ausgangsspannungsknoten (104) und eine Komponente (106; 110) mit einem positiven, thermischen Koeffizienten, verbunden zwischen dem Ausgangsspannungsknoten (104) und dem Erdungsspannungsanschluß (Vss) zum Erhöhen der Ausgangsspannung (V104) mit einem Erhöhen der Temperatur besitzt; und
einen zweiten Schaltkreisabschnitt, der eine Komponente (108; 108') mit einem negativen, thermischen Koeffizienten, verbunden zwischen dem Referenzspannungsanschluß und dem Ausgangsspannungsknoten zum Erniedrigen der Referenzspannung (Vref) relativ zu der Ausgangsspannung (V104) mit einem Erhöhen der Temperatur besitzt;
wobei die Komponenten mit positivem und negativem, thermischen Koeffizienten einander ausgleichen, um die Referenzspannung (Vref) in Bezug auf Temperaturvariationen zu stabiliseren.

2. Referenzspannungs-Erzeugungsschaltkreis nach Anspruch 1, wobei die Komponente mit einem positivem, thermischen Koeffizienten ein NMOS-Transistor (106) ist und wobei der Kanal des NMOS-Tansistors (106) in Serie zwischen dem Ausgangsspannungsknoten und dem Erdungsspannungsanschluß (Vss) verbunden ist.

3. Referenzspannungs-Erzeugungsschaltkreis nach Anspruch 2, wobei
der NMOS-Tansistor (106) sein Gatter mit dem Quellenspannungsanschluß oder dem Referenzspannungsanschluß verbunden besitzt.

4. Referenzspannungs-Erzeugungsschaltkreis nach einem vorhergehenden Anspruch, wobei die Komponente mit einem negativen, thermischen Koeffizienten ein PMOS-Transistor (108) ist, dessen Kanal zwischen dem Referenzspannungsanschluß und dem Erdungsspannungsanschluß (Vss) verbunden ist und dessen Gatter mit dem Ausgangsspannungsknoten (104) verbunden ist.

5. Referenzspannungs-Erzeugungsschaltkreis nach Anspruch 4, wobei das Substrat des PMOS-Transistors mit dem Referenzspannungsanschluß verbunden ist.

6. Referenzspannungs-Erzeugungsschaltkreis nach einem vorhergehenden Anspruch, der weiterhin eine Rückkopplungseinrichtung zum Zurückführen der Referenzspannung zu der Komponenten mit positivem, thermischen Koeffizienten, um beim Stabilisieren der Referenzquellenspannung zu unterstützen, aufweist.

7. Referenzspannungs-Erzeugungsschaltkreis nach Anspruch 2 oder Anspruch 3, der weiterhin einen zweiten NMOS-Transistor (110), dessen Kanal zwischen dem Ausgangsspannungsknoten (104) und der Source des ersten NMOS-Transistors (106) verbunden ist und dessen Gatter mit dem Referenzspannungsanschluß verbunden ist, aufweist.

8. Referenzspannungs-Erzeugungsschaltkreis nach Anspruch 7, wobei der erste und der zweite NMOS-Transistor mit deren Kanälen parallel verbunden sind.

9. Referenzspannungs-Erzeugungsschaltkreis nach Anspruch 2 oder 3, wobei die Komponente mit einem negativen, thermischen Koeffizienten einen PMOS-Transistor (108) aufweist, dessen Kanal zwischen dem Referenzspannungsanschluß und dem Erdungsspannungsanschluß (Vss) verbunden ist und dessen Gatter mit dem Ausgangsspannungsknoten (104) verbunden ist, der weiterhin einen zweiten PMOS-Transistor (108') aufweist, dessen Kanal parallel zu dem Kanal des ersten PMOS-Transistors (108) verbunden ist.

10. Referenzspannungs-Erzeugungsschaltkreis nach Anspruch 7, 8 oder 9, wobei die Substrate des ersten und des zweiten NMOS-Transistors (106, 110) gemeinsam zu entweder der Erdungsspannung oder der Rückführspannung verbunden sind.

## Revendications

1. Circuit de génération de tension de référence pour convertir une tension de source (Vcc) en une tension de référence (Vref), le circuit comprenant :
- une borne de tension de source pour recevoir la tension de source (Vcc) ;
- une borne de tension de masse pour recevoir une tension de masse ;
- une borne de tension de référence pour fournir en sortie la tension de référence (Vref) ;
- une première partie de circuit (100, 102, 106 ; 110) branchée entre la borne de tension de source et la borne de tension de masse (Vss), cette première partie de circuit comportant un noeud de tension de sortie (104) et un noeud de tension de référence (101) pour le branchement à la borne de tension de référence, noeuds de tension dont on peut dériver respectivement la tension de référence (Vref) et la tension de sortie (V104), la première partie de circuit comportant une première résistance (100) entre la borne de tension de source (Vcc) et le noeud de tension de référence (101), une seconde résistance (102) entre le noeud de tension de référence (101) et le noeud de tension de sortie (104), et un composant à coefficient de température positif (106 ; 110) branché entre le noeud de tension de sortie (104) et la borne de tension de masse (Vss) pour augmenter la tension de sortie (V104) lorsque la température augmente ; et
- une seconde partie de circuit comportant un composant à coefficient de température négatif (108 ; 108') branché entre la borne de tension de référence et le noeud de tension de sortie, pour diminuer la tension de référence (Vref) par rapport à la tension de sortie (V104) lorsque la température augmente ;
dans lequel
le coefficient de température positif et le coefficient de température négatif se contrebalancent l'un l'autre de manière à stabiliser la tension de référence (Vref) par rapport aux variations de température.

2. Circuit de génération de tension de référence selon la revendication 1,
dans lequel
le composant à coefficient de température positif est un transistor NMOS (106) et la jonction de ce transistor NMOS (106) est branchée en série entre le noeud de tension de sortie et la borne de tension de masse (Vss).

3. Circuit de génération de tension de référence selon la revendication 2,
dans lequel
le transistor NMOS (106) a sa grille branchée à la borne de tension de source ou à la borne de tension de référence.

4. Circuit de génération de tension de référence selon l'une quelconque des revendications précédentes,
dans lequel
le composant à coefficient de température négatif est un transistor PMOS (108) dont la jonction est branchée entre la borne de tension de référence et la borne de tension de masse (Vss), tandis que sa grille est branchée au noeud de tension de sortie (104).

5. Circuit de génération de tension de référence selon la revendication 4,
dans lequel
le substrat du transistor PMOS est connecté à la borne de tension de référence.

6. Circuit de génération de tension de référence selon l'une quelconque des revendications précédentes,
comprenant en outre
un moyen de rétroaction pour renvoyer en rétroaction la tension de référence au composant à coefficient de température positif, de manière à contribuer à la stabilisation de la tension de source de référence.

7. Circuit de génération de tension de référence selon la revendication 2 ou la revendication 3,
comprenant en outre
un second transistor NMOS (110) dont la jonction est branchée entre le noeud de tension de sortie (104) et la source du premier transistor NMOS (106), et dont la grille est connectée à la borne de tension de référence.

8. Circuit de génération de tension de référence selon la revendication 7,
dans lequel
le premier transistor NMOS et le second transistor NMOS sont branchés de façon que leurs jonctions soient en parallèle.

9. Circuit de génération de tension de référence selon la revendication 2 ou la revendication 3,
dans lequel
le composant à coefficient de température négatif comprend un transistor PMOS (108) dont la jonction est branchée entre la borne de tension de référence et la borne de tension de masse (Vss) et dont la grille est connectée au noeud de tension de sortie (104), le circuit comprenant en outre un second transistor PMOS (108') dont la jonction est branchée en parallèle sur la jonction du premier transistor PMOS (108).

10. Circuit de génération de tension de référence selon la revendication 7, 8 ou 9,
dans lequel
les substrats du premier transistor NMOS (106) et du second transistor NMOS (110) sont branchés en commun soit à la tension de masse soit à une tension de contre-polarisation.
